# EUROPÄISCHE PATENTSCHRIFT

(11) **EP 2 099 950 B1**
(45) Veröffentlichungstag und Bekanntmachung des Hinweises auf die Patenterteilung: **16.05.2012**
(21) Anmeldenummer: 07856237.8
(22) Anmeldetag: 23.11.2007
(51) Int. Cl.: C23C 14/20, B60Q 3/04, G09F 13/08, H01H 9/18

(54) **BEDIENELEMENT MIT METALLISCHER BESCHICHTUNG FÜR EIN KRAFTFAHRZEUG**
CONTROL ELEMENT COMPRISING A METALLIC COATING FOR A MOTOR VEHICLE
ÉLÉMENT DE COMMANDE COMPORTANT UN REVÊTEMENT MÉTALLIQUE POUR UN VÉHICULE

(30) Priorität: 24.11.2006 DE 102006055971
(43) Veröffentlichungstag der Anmeldung: 16.09.2009
(73) Patentinhaber: PREH GmbH, 97616 Bad Neustadt (DE)
(72) Erfinder: LUST, Matthias, 74080 Heilbronn (DE); KÜCHLER, Wolfgang, 97645 Ostheim (DE)
(74) Vertreter: Lohmanns, Bernard
(86) Internationale Anmeldenummer: PCT/EP2007/010204
(87) Internationale Veröffentlichungsnummer: WO 2008/061786

(56) Entgegenhaltungen:
- DE-A1- 10 337 456
- DE-A1-102005 006 459
- DE-B3- 10 341 623
- DE-B3-102005 032 717

## Beschreibung

Die Erfindung betrifft ein Bedienelement für ein Kraftfahrzeug bestehend zumindest aus einem Kunststoffgrundkörper und einer auf den Kunststoffgrundkörper vollflächig aufgebrachten, durchleuchtbaren metallischen Beschichtung, wobei die metallische Beschichtung mittels eines PVD-Verfahrens aufgetragen ist.

Um die verschiedenen Einstellungen in einem Kraftfahrzeug, wie beispielsweise das Raumklima oder ein Navigationssystem, steuern zu können sind im Kraftfahrzeug Drehsteller, Tasten, Schalter oder vergleichbare Eingabehilfen angeordnet. Ein Bestreben der Automobilindustrie ist es hierbei die Bedienelemente derart an die Innenausstattung anzupassen, dass diese eine hochwertige und metallische Anmutung aufweisen, ohne direkt aus Metall gefertigt zu sein. Einerseits dient das metallische Aussehen dazu die Bedienelemente hochwertig aussehen zu lassen und andererseits gibt die metallische Beschichtung dem Bediener das Gefühl metallische Bedienelemente zu betätigen.

Da in modernen Kraftfahrzeugen die Anzahl der Bedienelemente in Form von Druckschaltern, Tastern, Wippen. Drehschaltern oder kombinierten Drück- und Drehstellern stark zugenommen hat, ist es ein weiteres Bestreben der Automobilindustrie, die durch die Bedienelemente zu steuernden Funktionen nur dann darzustellen, wenn diese, unter Voraussetzung einer ausgewählten Funktion, zur Verfügung stehen. Stehen diese Funktionen der Bedienelemente nicht zur Auswahl, so wird auch kein Symbol in diesem Bedienelement zur Anzeige gebracht. Diese Technik wird auch als Verschwindetechnik bezeichnet. Steht hingegen die Funktion des Bedienelementes zur Verfügung, so wird dass Bedienelement hinterleuchtet und so ein in dem Bedienelement eingebrachtes Symbol und/oder eine Schrift zur Anzeige gebracht. Ist beispielsweise das Bedienelement eine Drucktaste, mit der das Öffnen und Schließen eines Cabrioverdeckes gesteuert wird, so ist diese Drucktaste im Stillstand des Kraftfahrzeuges funktionsfähig und somit hinterleuchtet, so dass der Bediener das Cabrioverdeck Öffnen und Schließen kann. Während der Fahrt steht diese Funktion dem Bediener nicht zur Verfügung, so dass das Funktionssymbol nicht angezeigt wird. Hierdurch ist somit zusätzlich eine höhere Bediensicherheit im Kraftfahrzeug erreichbar.

Eine Bedieneinrichtung mit abdunkelbaren Bedienelementen, bei dem die Bedienelemente eine nahezu einheitliche, der Oberfläche des Bedienelementes angepasste Farbe aufweisen ist in der DE 103 41 623 B3 beschrieben. Die Bedieneinrichtung besteht aus durchleuchtbaren Funktionssymbolen, wobei der durchleuchtbare Bereich des Funktionssymbols mit einer elektrochromen Schicht versehen ist, so dass das Funktionssymbol abdunkelbar ist.

Das Aufbringen metallischer Schichten auf Kunststoffbauteilen mit einem Anzeigebereich ist in der DE 10 2005 006 459 aufgezeigt. Das metallisierte Kunststoffbauteil, das insbesondere ein Bedienelement für ein Kraftfahrzeug ist, wird mittels eines PVD-Verfahrens mit einer metallischen Deckschicht versehen, so dass das Kunststoffbauteil ein metallisches Aussehen und eine metallische Haptik erhält.

Ein gattungsgemäßer Stand der Technik ist in der DE 10 2005 032 717 B3 offenbart. Offenbart ist eine Bedieneinheit, die einen mit einer Oberflächenbeschichtung versehenen lichtdurchlässigen Kunststoffgrundträger aufweist, wobei der Kunststoffgrundträger einen ersten Bereich mit einer lichtundurchlässigen Oberflächenbeschichtung und einen zweiten Bereich mit einer lichtdurchlässigen Oberflächenbeschichtung aufweist und die lichtundurchlässige Oberflächenbeschichtung eine sichtbare metallische Beschichtung enthält, wobei die lichtdurchlässige Oberflächenbeschichtung eine sichtbare lichtdurchlässige metallische Beschichtung enthält und die metallische Beschichtung der lichtdurchlässigen Oberflächenbeschichtung und die metallische Beschichtung der lichtundurchlässigen Oberflächenbeschichtung ein unterschiedliches optische Erscheinungsbild aufweisen. Der Kunststoffgrundträger wird zunächst vollständig mit einer Lackschicht versehen, die anschließend in einem Bereich, die ein Symbol darstellt, mittels eines Laserstrahls entfernt wird. Danach wird die äußere Oberfläche, wobei hiermit der mit der Lackschicht versehene Bereich und der Bereich gemeint ist, in dem die Lackschicht mit dem Laser abgetragen wurde, mit einer metallischen Beschichtung versehen. Die metallische Beschichtung wird hierbei vorzugsweise mittels eines PVD-Verfahrens aufgetragen. Um eine Durchleuchtbarkeit des Bedienelementes zu gewährleisten, ist die gesamte Schichtdicke der metallischen Beschichtung so gering, das Licht von einer Lichtquelle durch die metallische Beschichtung hindurch treten kann. Durch die unterschiedlichen Oberflächenrauhigkeiten der Lackschicht und des freigelaserten Bereichs ist das Symbol aufgrund des unterschiedlichen Glanzgrades der Oberflächen auch im unbeleuchteten Zustand sichtbar.

Die DE 103 37 456 A1 offenbart ein Bauteil aus einem Kunststoffgrundkörper und einer auf den Kunststoffarundköroer vollflächig aufgetragenen metallischen Beschichtung, wobei das Bauteil ein Bedienelement sein kann.

Der Erfindung liegt die Aufgabe zugrunde, ein Bedienelement bereitzustellen, das eine metallische Beschichtung aufweist und gleichzeitig die Möglichkeit der Darstellung eines Symbols ermöglicht, wobei das Symbol in Verschwindetechnik im funktionslosen Zustand nicht sichtbar ist. Darüber hinaus besteht die Aufgabe darin, eine konstruktiv einfache und kostengünstige Lösung bereitzustellen.

Die Aufgabe der Erfindung wird dadurch gelöst, dass die metallische Beschichtung unmittelbar und homogen auf den Kunststoffgrundkörper aufgetragen ist und eine Schichtdicke von 5 nm bis 100 nm aufweist. Erfindungsgemäß ist ferner eine auf der Innenseite des Grundkörpers befindliche opake Lackschicht vorgesehen, wobei die opake Lackschicht lackfreie Symbolbereiche aufweist. Erfindungsgemäß ist ferner ein Leuchtmittel vorgesehen, mit dem der Kunststoffgrundkörper durchleuchtbar ist, so dass ein mittels des Leuchtmittels erzeugtes Licht durch die Symbolbereiche sichtbar ist. Durch die erfindungsgemäße Ausbildung des Bedienelementes mit einer unmittelbar auf den Kunststoffgrundkörper aufgebrachten metallischen Beschichtung, ist nun die Möglichkeit geschaffen, ein Bedienelement bereitzustellen, das mittels einer Beleuchtung durchleuchtbar ist und gleichzeitig im unbeleuchteten Zustand das Aussehen eines metallisch beschichteten oder metallischen Bedienelementes aufweist. Es ist erfindungsgemäß somit möglich, ein Bedienelement darzustellen, das einerseits eine frei von Symbolen und/oder Piktogrammen und/oder Beschriftungen Oberfläche aufweist, solange eine Hinterleuchtung nicht eingeschaltet ist, und das gleichzeitig in der Lage ist, eine Funktion mit Hilfe eines Piktogramms und/oder eines Symbols und/oder einer Schrift anzuzeigen.

Dies bietet einerseits den Vorteil, das Piktogramme, Symbole oder Schriften anzeigbar sind, die aber andererseits auch wahlweise ohne Symbol als Bedienelemente zur Verfügung stehen.

Nachfolgend wird die Erfindung anhand alternativer Ausführungsformen in schematischen Skizzen erläutert.

Es zeigen:
- Figur 1: den Schnitt durch ein erfindungsgemäß, von einer Ruckseite lackiert ausgebildetes Bedienelement,

- Figur 2: den seitlichen Schnitt durch ein aus verschiedenen Kunststoffen hergestelltes alternatives Bedienelement,
- Figur 3: den seitlichen Schnitt durch ein alternatives Bedienelement, bei dem in das Bedienelement eine Folie eingefügt ist und
- Figur 4: den seitlichen Schnitt durch ein weiteres alternatives Bedienelement, bei dem in das Bedienelement eine Folie eingefügt ist.

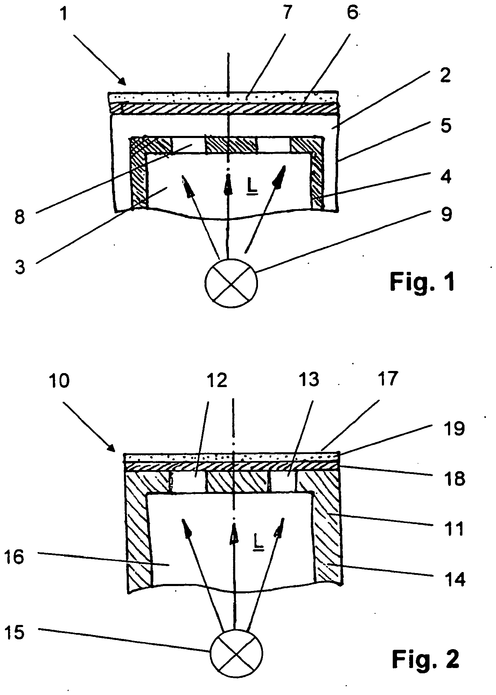

In der Figur 1 ist ein Schnitt einer Seitenansicht auf ein Bedienelement 1 dargestellt. Ein Kunststoffgrundkörper 2 ist von seiner Innenseite 3 her mit einer opaken Lackschicht 4 versehen. Auf die äußere Oberfläche 5 des Kunststoffgrundkörpers ist vollflächig eine metallische Beschichtung 6 aufgetragen, wobei vollflächig natürlich auch die gesamte äußere Oberfläche 5 des Bedienelementes 1 einschließt. Der leichteren Darstellbarkeit wegen, ist in der Figur 1 lediglich, die einem Bediener zugewandte Oberfläche 5, mit einer Beschichtung 6 gezeigt. Über der metallischen Beschichtung 6 ist zusätzlich eine Klarlackschicht 7 aufgebracht.

In die opake Lackschicht 4 ist ein Symbol und/oder ein Piktogramm und/oder eine Schrift 8 eingebracht. Dieses Symbol 8 ist zum Beispiel mittels eines Lasers in die Lackschicht 4 einbringbar oder die Lackschicht 4 ist über eine auf die Innenseite des Kunststoffgrundkörpers 2 aufgebrachte Schablone aufgetragen, so dass der Symbolbereich 8 lackfrei geblieben ist. Die Lackschicht 4 besteht aus einem opaken Werkstoff, so dass ein mittels eines Leuchtmittels 9 erzeugtes Licht L lediglich durch die Symbolbereiche 8 hindurch sichtbar ist.

Der Kunststoffgrundkörper 2 ist aus einem transparenten oder eingefärbtem Werkstoff wie beispielsweise Polycarbonat (PC) oder Polymethylmethacrylat (PMMA) hergestellt. Der Kunststoffgrundkörper 2 kann erfindungsgemäß ein Druckknopf, ein Drehsteller, eine Wipptaste oder ein Multifunktionseingabe-Bedienelement sein. Vorstellbar ist auch, dass der dargestellte Kunststoffgrundkörper 2 ein Drehknopf für so genannte weiße Ware oder ein elektrisches Gerät einer Unterhaltungselektronik ist. Neben der Ausführung des Kunststoffgrundkörpers als Bedienelement 1, ist die Erfindung ebenfalls auf lediglich visuell durchleuchtbare Bereiche, wie beispielsweise eine Coronabeleuchtung oder Anzeigestriche oder Anzeigesymbole in einem Bedienelement 1 zum Beispiel einer Klimaanlage eines Kraftfahrzeuges anwendbar. Erfindungswesentlich ist, dass der Kunststoffgrundkörper in dieser Ausführungsvariante auf seiner Innenseite 3 lackiert, auf der Außenseite 5 metallisch beschichtet und mittels des Leuchtmittels 9 durchleuchtbar ist.

Auf der äußeren Oberfläche 5 des Kunststoffgrundkörpers ist eine metallische Beschichtung 6 aufgetragen, wodurch der Kunststoffgrundkörper ein metallisches Aussehen erhält. Durch das vollflächige homogene Auftragen unmittelbar auf den Kunststoffgrundkörper 2 wird eine gleichmäßige einheitliche Oberfläche 5 am Bedienelement 1 erzeugt, was sich für den Bediener in einer angenehmen Haptik widerspiegelt und einen optisch qualitativen Eindruck vermittelt. Ist in der Figur 1 die metallische Beschichtung 6 lediglich auf einer Seite des Kunststoffgrundkörpers aufgetragen, so handelt es sich lediglich um ein Ausführungsbeispiel, wobei natürlich die gesamte Oberfläche 5 des Kunststoffgrundkörpers 2 mit einer metallischen Beschichtung 6 beaufschlagbar ist. Um eine ausreichende Durchleuchtbarkeit und Darstellbarkeit eines Symbols 8 am Bedienelement 1 darzustellen, ist die metallische Beschichtung 6 in einem Schichtdickenbereich von 5 nm bis 100 nm auf dem Kunststoffgrundkörper 2 aufgetragen. Dies gewährleistet einerseits, dass der Kunststoffgrundkörper 2 vollständig abgedeckt, das heißt der Werkstoff des Kunststoffgrundkörpers nicht mehr sichtbar ist und andererseits eine metallische Optik erzielt ist.

Zur weiteren Verbesserung der optischen Anmutung des Bedienelementes, wie auch der Verbesserung der Reinigung des Bedienelementes wird erfindungsgemäß vorgeschlagen, das Bedienelement 1 mit einer Klarlackschicht 7 zu versehen.

Eine weitere Möglichkeit das Aussehen des Symbols 8 im Bedienelement 1 zu beeinflussen, ist die, den Werkstoff des Kunststoffgrundkörpers 2 einzufärben. Dies ermöglicht es, dass unterschiedliche Leuchtdichten und Farbgestaltungen am Bedienelement 1 einstellbar und darstellbar sind.

In der Figur 2 ist eine alternative Ausführungsform der Erfindung in einem Schnitt durch ein Bedienelement 10 in der Seitenansicht wiedergegeben. Der Kunststoffgrundkörper 11 ist aus einem opaken Kunststoff hergestellt, der Bereichsweise 12, 13 zusätzliche transparente oder transparent eingefärbte Kunststoffbereiche 12, 13 aufweist. Diese Ausführungsform eines erfindungsgemäßen Bedienelementes ermöglicht eine kostengünstige Fertigung, da das Herstellen eines derartigen Kunststoffgrundkörpers 11 aus opaken 14 und transparenten Bereichen 12, 13 in einem Arbeitsgang und einstückig möglich ist. Das Licht L eines Leuchtmittels 15 hinterleuchtet die Innenseite 16 des Bedienelementes 11, so dass das Licht L durch die transparenten Bereiche 12, 13 hindurchtritt und an der Oberseite 17 des Bedienelementes 10 sichtbar ist.

Das erfindungsgemäße Bedienelement gemäß der Figur 2 weist ebenso eine metallische Beschichtung 18 sowie eine optionale Klarlackschicht 19 auf.

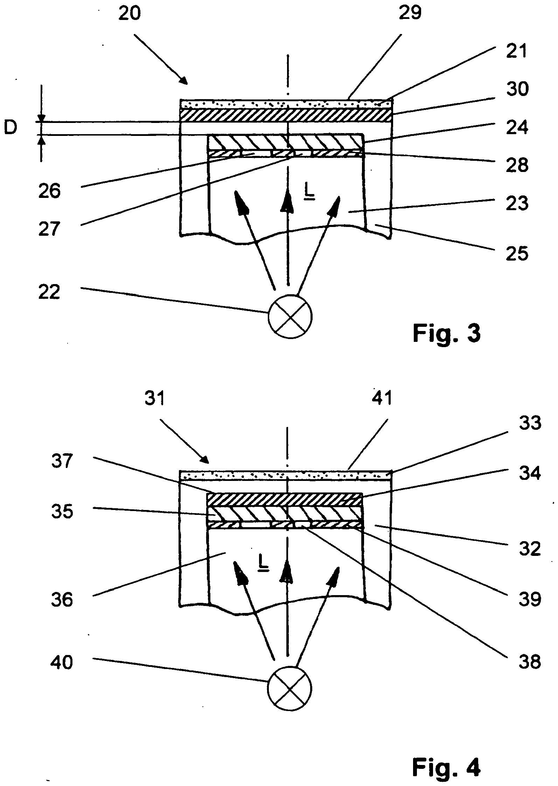

In der Figur 3 ist die Seitenansicht auf ein erfindungsgemäß ausgebildetes alternatives Bedienelement 20 dargestellt. Dargestellt ist eine Seitenansicht im Schnitt durch das Bedienelement 20 in prinzipieller Form mit einer optionalen Klarlackschicht 21. In eine mit einem Leuchtmittel 22 beleuchtete Innenseite 23 des Bedienelementes 20 ist eine Folie 24 eingefügt und im Bedienelement 20 befestigt. Die Folie ist beispielsweise aus einem PC-Kunststoff hergestellte Folie 24, die wie der Kunststoffgrundkörper 25 transluzent ausgeführt ist. Damit mittels des Lichtes L des Leuchtmittels 22 ein Symbol 26, 27 am Bedienelement 20 erzeugbar ist, ist die Folie 24 einseitig bedruckt. Der Druck ist beispielsweise aus einem opaken Lack 28 erzeugbar, so dass das Licht L lediglich durch den Bereich des Symbols 26, 27 hindurchleuchtet, und an der Oberseite 29 des Bedienelementes 20 als Symbol 26, 27 sichtbar ist.

Die Verwendung einer bedruckten Folie 24 bietet den Vorteil, dass diese Folie 24 sehr leicht als Großserie herstellbar ist. Darüber hinaus entfällt der Arbeitsgang des Lackierens auf der Innenseite 23 des Bedienelementes 20. Die Dicke der Folie 24 ist hierbei in Dickenbereichen von 0,05 mm bis 2 mm ausführbar. Je nach Dicke der Folie 24 ist die Folie 24 in die Innenseite 23 des Bedienelementes 20 eingeklebt und/oder eingeklemmt. Dabei ist die Folie 24 auch derart ausbildbar, dass die Innenseite 23 vollflächig und vollständig abgedeckt ist, so ist die Folie 24 auch in Form einer Kappe oder Hütchen ausführbar und in der Innenseite 23 befestigbar. Die Dicke D des durchleuchteten Kunststoffgrundkörpers 25 liegt zwischen 0,5 mm bis 8 mm und ist abhängig von dem ausgewählten Werkstoff für den Kunststoffgrundkörper 25.

Auf den Kunststoffgrundkörper 25 ist auf die Bedienerseite 29 und/oder vollflächig an der oder den Außenseiten eine durchleuchtbare metallische Beschichtung 30 aufgetragen.

In der Figur 4 ist eine weitere alternative Ausführungsform eines Bedienelementes 31 in einer Seitenansicht im Schnitt dargestellt. Der Schnitt des Bedienelementes 31 stellt im Prinzip eine Tastenkappe, wie sie beispielsweise bei Druckknöpfen einsetzbar ist, dar. Der Kunststoffgrundkörper 32 ist mit einer optionalen Klarlackschicht 33 versehen. Im Gegensatz zu den alternativen Ausführungsformen der Erfindung, gemäß der vorgenannten Beispiele, ist die durchgängige metallische Beschichtung 34 auf einer Folie 35 aufgebracht. Die Folie ist hierbei im Inneren 36 des Bedienelementes derart befestigt, dass die metallische Beschichtung 34 an der einem Bediener zugewandten Innenoberfläche 37 der Innenseite 36 des Bedienelementes 31 vollflächig anliegt. Die Folie 35 ist, wie bereits unter der Figur 3 beschrieben, zur Darstellung eines Symbols 38 an einer dem Bediener abgewandten Seite mit einem opaken Lack 39 bedruckt. Die Folie 35 ist, wie oben bereits beschrieben, im Bedienelement 31 befestigbar.

Zur Darstellung eines Symbols auf dem Bedien- oder Anzeigeelement 31 ist ein Leuchtmittel 40 hinter der Folie 35 im Bedienelement 31 angeordnet. Hierbei kann das Licht L des Leuchtmittels 40 lediglich durch die zum Beispiel freigelaserten Bereiche 38 der Lackschicht 39 hindurchtreten, und an die Oberfläche 41 zur Darstellung eines Symbols austreten.

Ein Vorteil dieser alternativen Ausführungsform ist der, dass die beschichtete und lackierte Folie 35 als Einlegeteil in das Bedienelement 31 einfügbar ist. Hierbei ist es möglich, die Folie 35 in das Bedienelement 31 einzukleben oder unter Bildung eines Luftspalts in das Bedienelement 31 einzufügen. Zur Darstellung einer metallischen Optik wird für den Kunststoffgrundkörper 32 vorzugsweise ein transparenter Werkstoff verwendet.

Die metallische Beschichtung 6, 19, 30 der Bedienelemente 1, 10, 20 ist beispielsweise aus Molybdän (Mo), Chrom (Cr) oder Aluminium (Al) herstellbar. Sie wird mittels eines PVD-Verfahrens aufgetragen, wobei dieses Verfahren zur metallischen Beschichtung mittels eines PVD-Verfahrens aus dem Stand der Technik wie beispielsweise der DE 10 2005 006 459 A1 bekannt ist.

Mit der Bereitstellung eines Bedienelementes 1, 10 20 gemäß der Erfindung ist nun ein Bedienelement 1, 10, 20 darstellbar, dass eine glatte, ohne ein ständig sichtbares Symbol, ein Piktogramm oder eine Beschriftung versehene Oberfläche aufweist. Lediglich mittels der Hinterleuchtung des Bedienelements 1, 10, 20 wird das Symbol 8, 12, 13, 26, 27 am Bedienelement 1, 10, 20 sichtbar.

## Patentansprüche

1. Bedienelement bestehend zumindest aus einem Kunststoffgrundkörper (2, 11, 25) und einer auf einer einem Bedienelement zugewandten Oberfläche auf den Kunststoffgrundkörper (2, 11, 25) vollflächig aufgetragenen, durchleuchtbaren metallischen Beschichtung (6, 18, 30), wobei die metallische Beschichtung (6, 18, 30) mittels eines PVD-Verfahrens aufgetragen ist, **dadurch gekennzeichnet, dass** die metallische Beschichtung (6, 18, 30) unmittelbar, homogen auf dem Kunststoffgrundkörper (2, 11, 25) aufgetragen ist und eine Schichtdicke von 5 nm bis 100 nm aufweist und dass eine auf der Innenseite (3) des Grund-körpers (2) befindliche opake Lackschicht (4, 28, 32) vorgesehen ist wobei die opake Lackschicht lackfreie Symbolbereiche (8) a aufweist und durch ein Leuchtmittel (9) mit dem der Kunststoffgrundkörper durchleuchtbar ist, so dass ein mittels des Leuchtmittels erzeugtes Licht L durch die Symbolbereiche (8) sichtbar ist.

2. Bedienelement nach Anspruch 1, **dadurch gekennzeichnet, dass** der Kunststoffgrundkörper (2) aus einem klaren und/oder eingefärbten transparenten Kunststoff (2) gebildet ist und das Bedienelement (1) von einer Innenseite (3) mit einer opaken Lackschicht (4) versehen ist, wobei in die Lackschicht (4) ein Symbol und/oder eine Ziffer und/oder ein Piktogramm (8) eingebracht ist.

3. Bedienelement nach Anspruch 2, **dadurch gekennzeichnet, dass** das Symbol (8) in die Lackschicht (4) eingelasert ist.

4. Bedienelement nach Anspruch 1, **dadurch gekennzeichnet, dass** in eine Innenseite (23) des Kunststoffgrundkörpers (25) eine Kunststofffolie (24) eingebaut ist und dass die Kunststofffolie (24) opake Bereiche, insbesondere lackierte Bereiche, aufweist, so dass ein Symbol und/oder eine Ziffer und/oder ein Piktogramm (26, 27) einbringbar ist.

5. Bedienelement nach Anspruch 1, bestehend zumindest aus einem Kunststoffgrundkörper (32) und einer vollflächigen, durchleuchtbaren metallischen Beschichtung (34), wobei die metallische Beschichtung (34) mittels eines PVD-Verfahrens erzeugt ist, **dadurch gekennzeichnet, dass** in eine Innenseite (36) des Kunststoffgrundkörpers (32) eine Kunststofffolie (35) eingebaut ist, dass die metallische Beschichtung (34) unmittelbar, homogen und auf einer einer inneren Oberfläche (37) zugewandten Seite auf die Kunststofffolie (35) aufgebracht ist und dass die Kunststofffolie (35) auf der der inneren Oberfläche (37) abgewandten Seite opake Bereiche (39), insbesondere lackierte Bereiche, aufweist, so dass ein Symbol und/oder eine Ziffer und/oder ein Piktogramm (38) darstellbar ist.

6. Bedienelement nach einem der Ansprüche 1 bis 5, dadurch gekennzeichneit dass auf die dem Bediener zugewandte Oberfläche des Bedienelementes (1, 10, 20, 31) eine Klarlackschicht (7, 17, 21) oder eine eingefärbte Klarlackschicht aufgetragen ist.

7. Bedienelement nach einem der Ansprüche 1 bis 6, **dadurch gekennzeichnet, dass** der Kunststoffgrundkörper (2, 11, 25, 32) einstückig ausgebildet ist.

8. Bedienelement nach einem der Anspruche 1 bis 7, **dadurch gekennzeichnet, dass** der Kunststoffgrundkörper (2, 11, 25, 32) eine Blende oder ein Drehsteller oder eine Taste in einem Kraftfahrzeug, insbesondere ein Bedienelement einer Klimaanlage, ist.

## Claims

1. A control element consisting at least of one plastic base body (2, 11, 25) and of a transilluminable metallic coating (6, 18, 30) applied to the plastic base body (2, 11, 25) over the entire surface area of a surface facing the control element, the metallic coating (6, 18, 30) being applied by means of a PVD method, **characterised in that** the metallic coating (6, 18, 30) is applied directly and homogeneously to the plastic base body (2, 11, 25) and has a coating thickness ranging from 5 nm to 100 nm and **in that** an opaque lacquer layer (4, 28, 32) is provided on the inside (3) of the base body (2), the opaque lacquer layer comprising symbol regions (8) that are free of lacquer, and by a lighting means (9) by means of which the plastic base body can be transilluminated, so that a light L generated by means of the lighting means is visible through the symbol regions (8).

2. Control element according to claim 1, **characterised in that** the plastic base body (2) is formed from a clear and/or coloured transparent plastic material (2) and that the control element (1) is provided from an inner side (3) with an opaque lacquer layer (4), a symbol and/or a digit and/or a pictogram (8) being incorporated in said lacquer layer (4).

3. Control element according to claim 2, **characterised in that** the symbol (8) is lasered into the lacquer layer (4).

4. Control element according to claim 1, **characterised in that** a plastic foil (24) is built into an inner side (23) of the plastic base body (25) and that the plastic foil (24) comprises opaque regions, in particular lacquered regions, so that a symbol and/or a digit and/or a pictogram (26, 27) can be incorporated.

5. Control element according to claim 1, consisting at least of one plastic base body (32) and of a transilluminable metallic coating (34) applied to the entire surface, the metallic coating (34) being generated by means of a PVD method, **characterised in that** a plastic foil (35) is built into an inner side (36) of the plastic base body (32), that the metallic coating (34) is applied to the plastic foil (35) directly, homogeneously and on a side facing towards an inner surface (37), and that the plastic foil (35) comprises opaque regions (39), in particular lacquered regions, on the side facing away from the inner surface (37) so that a symbol and/or a digit and/or a pictogram (38) can be depicted.

6. Control element according to any one of the claims 1 to 5, **characterised in that** a clear lacquer layer (7, 17, 21) or a coloured clear lacquer layer is applied to the surface of the control element (1, 10, 20, 31) facing towards the operator.

7. Control element according to any one of the claims 1 to 6, **characterised in that** the plastic base body (2, 11, 25, 32) is made from one piece.

8. Control element according to any one of the claims 1 to 7, **characterised in that** the plastic base body (2, 11, 25, 32) is a cover panel or a control dial or a button in a motor vehicle, in particular a control element of an air-conditioning system.

## Revendications

1. Elément de commande se composant au moins d'un corps de base en matière plastique (2, 11, 25) et d'un revêtement métallique (6, 18, 30) qui est appliqué sur ledit corps de base en matière plastique (2, 11, 25) sur toute la face d'une surface tournée vers un élément de commande et qui est apte à être transilluminé, ledit revêtement métallique (6, 18, 20) étant appliqué au moyen d'un procédé PVD, **caractérisé par le fait que** ledit revêtement métallique (6, 18, 30) est appliqué directement, de façon homogène sur ledit corps de base en matière plastique (2, 11, 25) et présente une épaisseur de couche comprise entre 5 nm et 100 nm et qu'une couche opaque en vernis (4, 28, 32) se trouvant sur la face intérieure (3) du corps de base (2) est prévue, ladite couche opaque en vernis présentant des zones de symbole (8) exemptes de vernis, ainsi que par un moyen d'éclairage (9) au moyen duquel ledit corps de base en matière plastique peut être transilluminé de sorte qu'une lumière L générée par l'intermédiaire dudit moyen d'éclairage est visible à travers lesdites zones de symbole (8).

2. Elément de commande selon la revendication 1, **caractérisé par le fait que** ledit corps de base en matière plastique (2) est réalisé dans une matière plastique claire et/ou transparente colorée (2) et que ledit élément de commande (1) est pourvu, depuis une face intérieure (3), d'une couche opaque en vernis (4), un symbole et/ou un chiffre et/ou un pictogramme (8) étant intégré à ladite couche en vernis (4).

3. Elément de commande selon la revendication 2, **caractérisé par le fait que** le symbole (8) est réalisé par laser dans ladite couche en vernis (4).

4. Elément de commande selon la revendication 1, **caractérisé par le fait qu'**une feuille en matière plastique (24) est intégrée à une face intérieure (23) dudit corps de base en matière plastique (25) et que ladite feuille en matière plastique (24) présente des zones opaques, en particulier des zones vernies de manière à ce qu'un symbole et/ou un chiffre et/ou un pictogramme (26, 27) puisse être intégré.

5. Elément de commande selon la revendication 1, se composant au moins d'un corps de base en matière plastique (32) et d'un revêtement métallique (34) appliqué sur toute la face et apte à être transilluminé, ledit revêtement métallique (34) étant produit au moyen d'un procédé PVD, **caractérisé par le fait qu'**une feuille en matière plastique (35) est intégrée à une face intérieure (36) du corps de base en matière plastique (32), que ledit revêtement métallique (34) est appliqué directement, de façon homogène sur ladite feuille en matière plastique (35) sur une face tournée vers la surface intérieure (37) et que ladite feuille en matière plastique (35) présente, sur la face montrant dans la direction opposée à ladite surface intérieure (37), des zones opaques (39), en particulier des zones vernies de manière à ce qu'un symbole et/ou un chiffre et/ou un pictogramme (38) puisse être représenté.

6. Elément de commande selon l'une quelconque des revendications 1 à 5, **caractérisé par le fait qu'**une couche de vernis clair (7, 17, 21) ou une couche de vernis clair colorée est appliquée sur la surface de l'élément de commande (1, 10, 20, 31) qui est tournée vers l'opérateur.

7. Elément de commande selon l'une quelconque des revendications 1 à 6, **caractérisé par le fait que** ledit corps de base en matière plastique (2, 11, 25, 32) est réalisé en une seule pièce.

8. Elément de commande selon l'une quelconque des revendications 1 à 7, **caractérisé par le fait que** ledit corps de base en matière plastique (2, 11, 25, 32) est un capot ou un actionneur rotatif ou une touche dans un véhicule automobile, en particulier un élément de commande d'une installation de conditionnement d'air.
